# FASCICULE DE BREVET EUROPEEN

(11) **EP 2 960 203 B1**
(45) Date de publication et mention de la délivrance du brevet: **06.11.2019**
(21) Numéro de dépôt: 15171976.2
(22) Date de dépôt: 12.06.2015
(51) Int. Cl.: B81B 3/00

(54) **DISPOSITIF À MEMBRANE À BASE DE GERMANIUM SOUS CONTRAINTE**
VORRICHTUNG MIT EINER MEMBRAN AUF DER BASIS VON UNTER ZUGBELASTUNG STEHENDEM GERMANIUM
GERMANIUM-BASED MEMBRANE DEVICE UNDER STRESS

(30) Priorité: 23.06.2014 FR 1455805
(43) Date de publication de la demande: 30.12.2015
(73) Titulaire: COMMISSARIAT À L'ÉNERGIE ATOMIQUE ET AUX ÉNERGIES ALTERNATIVES, 75015 Paris (FR)
(72) Inventeur: GUILLOY, Kévin, 38000 Grenoble (FR); PAUC, Nicolas, 38360 Sassenage (FR); CALVO, Vincent, 38600 Fontaine (FR); REBOUD, Vincent, 75013 Paris (FR)
(74) Mandataire: Novaimo

(56) Documents cités:
- GB-A- 2 501 307
- SUKHDEO DAVID S ET AL: "Mimicking heterostructure behavior within a single material at room temperature using strain", 2014 CONFERENCE ON LASERS AND ELECTRO-OPTICS (CLEO) - LASER SCIENCE TO PHOTONIC APPLICATIONS, THE OPTICAL SOCIETY, 8 juin 2014 (2014-06-08), pages 1-2, XP032708222,
- SHAH V A ET AL: "Tensile strained Ge membranes", 2014 15TH INTERNATIONAL CONFERENCE ON ULTIMATE INTEGRATION ON SILICON (ULIS), IEEE, 7 avril 2014 (2014-04-07), pages 137-140, XP032594299, DOI: 10.1109/ULIS.2014.6813917

## Description

L'invention concerne un dispositif optique et/ou électronique comprenant une membrane à base de germanium mise sous tension. Elle concerne aussi un procédé de fabrication d'un tel dispositif.

Il est connu que l'application d'une contrainte dans un cristal de germanium permet de modifier sa structure électronique et sa structure physique. Notamment, sa déformation permet de le rendre semi-conducteur à gap direct et de modifier sa sensibilité et son émission optiques vers les grandes longueurs d'onde supérieures à son gap direct non déformé, de 1.55 µm. Des applications de ces phénomènes ont été tentées, reposant sur une membrane de germanium suspendue mise sous tension par des bras. Toutefois, les méthodes existantes restent limitées car elles présentent tout ou partie des inconvénients suivants :
- Elles exercent des contraintes trop élevées lors du procédé de fabrication de la membrane de germanium, ce qui limite l'intensité de la tension accessible pour éviter la rupture de la membrane ;
- Elles exercent des tensions inhomogènes, formant des points faibles dans la membrane, ce qui limite aussi l'intensité de la tension maximale applicable et induit un comportement inhomogène nuisible à certaines applications.

Le document GB-2501307-A décrit une membrane de germanium suspendue mise sous tension par des bras.

Ainsi, un objet général de l'invention est donc de proposer une solution pour former un dispositif comprenant du germanium sous tension, qui ne présente pas tout ou partie des inconvénients des solutions existantes.

A cet effet, l'invention repose sur un dispositif optique et/ou électronique comprenant une membrane à base de germanium suspendue, comprenant une zone active mise en tension par des bras de traction, caractérisé en ce qu'il comprend au moins trois bras de traction comprenant des côtés latéraux non parallèles, dont la largeur augmente en s'éloignant de la zone active. Les côtés latéraux forment un angle obtus avec la zone active au niveau de la frontière entre le bras de traction et la zone active.

Il peut comprendre au moins un bras de traction de forme trapézoïdale. Tous les bras de traction peuvent présenter une même forme et être répartis de manière régulière autour de la zone active.

Il peut comprendre une zone active sensiblement polygonale, notamment formant un polygone régulier, dont le nombre de côtés est un multiple du nombre de bras de traction.

Il peut comprendre des liaisons arrondies au niveau de la périphérie de la zone active reliant deux bras de traction.

Le dispositif optique et/ou électronique peut être une diode, un transistor, un dispositif luminescent, un laser, un photodétecteur, un substrat.

Le dispositif optique et/ou électronique peut être un dispositif optique qui comprend un premier miroir sous la membrane à base de germanium et/ou un second miroir au-dessus.

L'invention porte aussi sur un procédé de fabrication d'un dispositif optique et/ou électronique, caractérisé en ce qu'il comprend les étapes suivantes :
- gravure d'une couche à base de germanium pour former au moins trois bras de traction comprenant des côtés latéraux non parallèles, dont la largeur augmente en s'éloignant d'une zone active, et dont les côtés latéraux forment un angle obtus avec la zone active au niveau de la frontière entre le bras de traction et la zone active;
- gravure d'une couche sacrificielle sous la couche à base de germanium pour obtenir une membrane à base de germanium suspendue comprenant la zone active et le au moins un bras de traction.

L'étape de gravure de la couche sacrificielle peut s'étendre progressivement du centre de la membrane, au niveau de la zone active, jusqu'au bord extérieur des bras de traction.

Le procédé de fabrication d'un dispositif optique et/ou électronique peut comprendre une étape de dépôt d'une couche réfléchissante pour former un miroir, notamment d'aluminium, sous la membrane et/ou une seconde étape de dépôt d'une couche réfléchissante pour former un miroir sur la membrane.

Ces objets, caractéristiques et avantages de la présente invention seront exposés en détail dans la description suivante d'un mode d'exécution particulier fait à titre non-limitatif en relation avec les figures jointes parmi lesquelles :
Les figures 1a à 1d représentent schématiquement des étapes d'un procédé de fabrication d'une structure à germanium sous tension selon un premier mode de réalisation de l'invention.
Les figures 2a à 2d représentent schématiquement des étapes d'un procédé de fabrication d'une structure à germanium sous tension selon un second mode de réalisation de l'invention.
La figure 3a représente un exemple de membrane en germanium suspendue par deux bras.
Les figures 3b à 3d représentent schématiquement en vue de dessus des membranes de germanium sous tension de dispositifs selon plusieurs variantes du mode de réalisation de l'invention.
La figure 4 représente en vue de dessus une membrane de germanium sous tension d'un dispositif.
Les figures 5a et 5b représentent des niveaux de déformation obtenus respectivement sur des membranes exemplaires.
La figure 6 représente des niveaux de déformation obtenus sur une membrane selon un autre exemple de réalisation de l'invention.
Les figures 7a à 7g représentent différentes étapes de fabrication d'un laser intégrant des membranes de germanium selon un mode de réalisation de l'invention.
La figure 8 représente la structure d'un laser selon un mode de réalisation de l'invention.

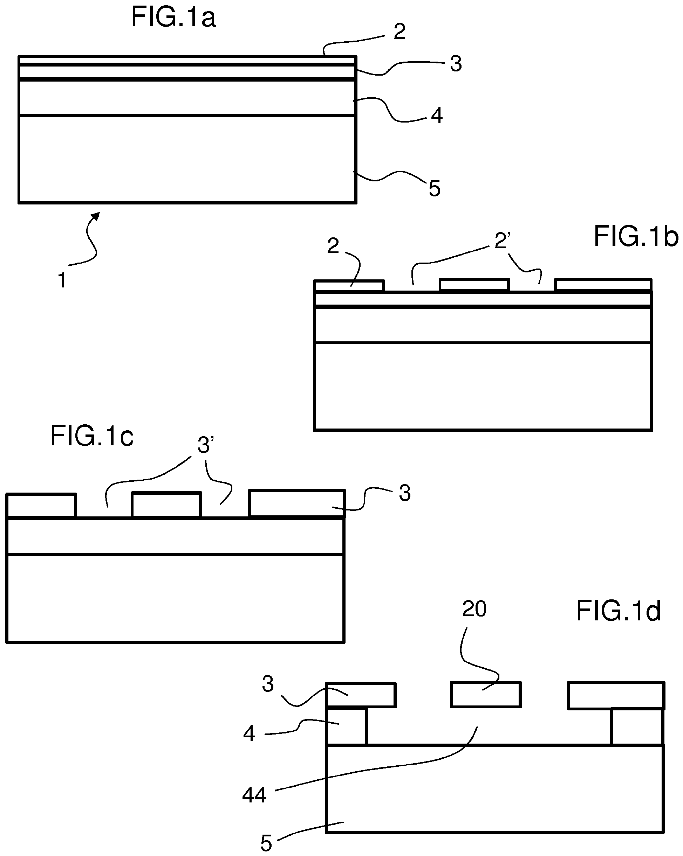

La figure 1a représente une vue schématique de côté en coupe d'une structure 1 réalisée en première phase d'un procédé de fabrication d'un dispositif selon un premier mode de réalisation de l'invention. Cette structure 1 comprend une couche supérieure 2 d'oxyde de silicium, très fine, par exemple de quelques nanomètres à 100 nm, qui recouvre une couche 3 en germanium, d'épaisseur de l'ordre de 100 nm à quelques microns. Elle comprend ensuite une couche 4 d'oxyde de silicium, d'épaisseur de l'ordre de 1 µm. Le tout est agencé sur un substrat 5 de silicium.

La figure 1b représente le résultat obtenu après une première étape consistant à lithographier des dessins sur la première couche supérieure 2 en utilisant par exemple une résine négative, avant de graver l'oxyde de silicium par exemple par gravure à l'argon. Il en résulte une couche supérieure 2 formant un masque dur, comprenant des ouvertures 2' traversantes.

La figure 1c représente la structure après une étape de gravure du germanium, réalisée par exemple par une technique connue par son acronyme RIE, pour la terminologie anglo-saxonne de Reactive Ion Etching. Cette étape de gravure reproduit dans la couche 3 de germanium les dessins formés dans la couche supérieure 2, pour former des ouvertures 3' traversantes dans la couche de germanium superposées aux ouvertures 2' de la couche supérieure 2.

La figure 1d représente la structure finale obtenue après une gravure de la couche 4 d'oxyde de silicium disposée sous le germanium, par exemple par gravure HF en phase vapeur ou liquide jusqu'à libération de la membrane, c'est-à-dire que la gravure est stoppée quand elle atteint latéralement la base des bras de traction. Il en résulte une membrane 20 de germanium suspendue au-dessus d'une cavité 44 formée dans la couche 4 d'oxyde de silicium, au-dessus du substrat 5 de silicium. La couche 4 d'oxyde de silicium sert donc ici de couche sacrificielle, et suite à son retrait par gravure, la membrane 20 de germanium se retrouve automatiquement sous tension, par les propriétés intrinsèques de la structure résultante.

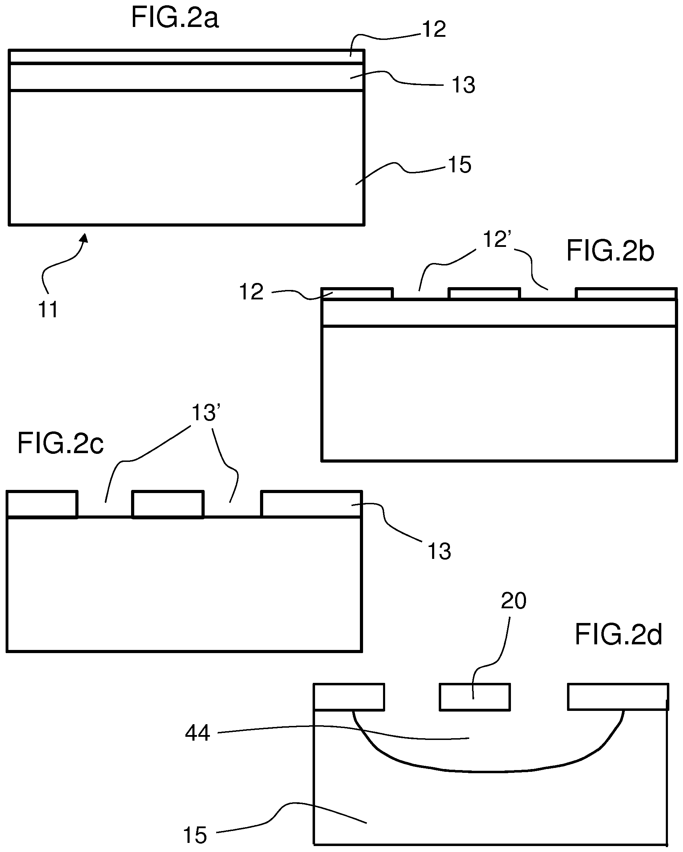

La figure 2a représente une vue schématique en coupe de côté d'une structure 11 réalisée en première phase d'un procédé de fabrication d'un dispositif selon un second mode de réalisation de l'invention. Cette structure 11 comprend de même une couche supérieure 12 d'oxyde de silicium, qui recouvre une couche 13 en Germanium, elle-même directement épitaxée sur un substrat 15 de silicium.

La figure 2b représente le résultat obtenu après une première étape similaire à l'étape décrite dans le premier mode de réalisation, consistant à lithographier des dessins sur la première couche supérieure 12 de gravure de l'oxyde de silicium pour former une couche supérieure 12 comprenant des ouvertures 12' traversantes pour former un masque pour la prochaine étape de gravure du germanium.

La figure 2c représente ainsi la structure résultante après cette étape de gravure du germanium, qui reproduit dans la couche 13 de germanium les dessins de la couche supérieure 12, en formant des ouvertures 13' traversantes dans la couche de germanium, superposées aux ouvertures 12' de la couche supérieure 12.

La figure 2d représente la structure finale obtenue après une gravure de la couche 15 de silicium pour former une cavité 44 disposée sous le germanium, par exemple par gravure humide à l'hydroxyde de tétraméthylammonium (TMAH), qui grave sélectivement le silicium par rapport au germanium à une profondeur suffisante pour libérer la membrane. Dans ce second mode de réalisation, la couche 15 de silicium remplit donc ici la fonction de couche sacrificielle. Il en résulte une membrane 20 de germanium sous tension suspendue.

Comme cela ressort des descriptions ci-dessus des deux modes de réalisation, les procédés utilisés sont avantageusement similaires et compatibles avec les procédés CMOS utilisés pour la fabrication des composants électroniques à base de silicium.

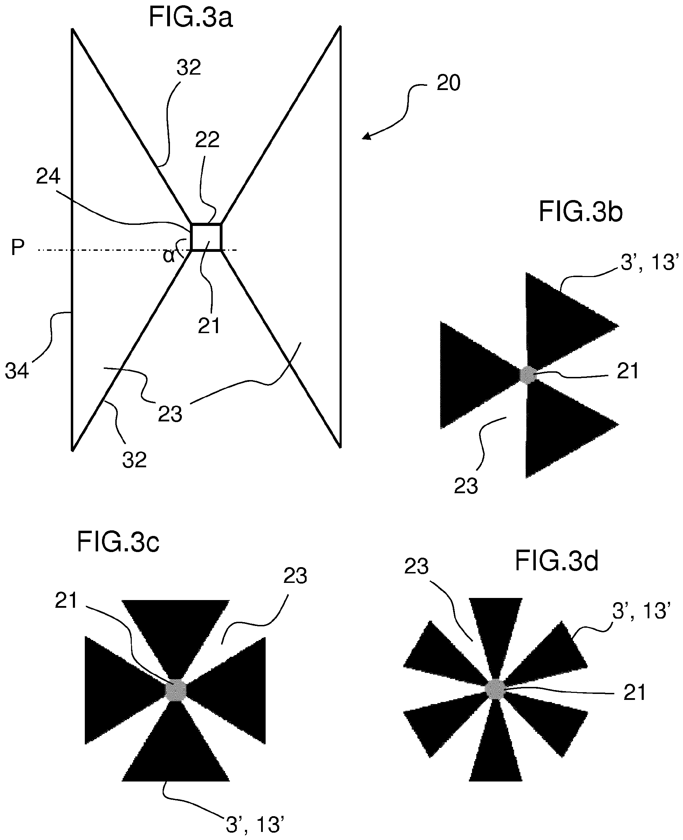

Selon le mode de réalisation de l'invention, les gravures effectuées dans les étapes précédentes des procédés de fabrication, formant des ouvertures 2', 3', 12', 13' pour obtenir finalement une membrane 20 de germanium suspendue, présentent une forme particulière avantageuse. Les figures 3a à 3d représentent à titre d'exemples de réalisation des formes de membranes 20 de germanium selon différentes variantes de réalisation de l'invention. Ces figures montrent en effet en vues de dessus des structures telles que représentées en coupe de côté par les figures 1d et 2d. Chaque membrane 20 se décompose en une partie centrale, dite zone active 21 ou zone d'intérêt, où se concentre la tension qui permet de doter la zone active 21 de propriétés optiques, électroniques et structurelles intéressantes, sous l'effet de bras de traction 23, reliant la zone active 21 au reste de la structure.

Selon un mode de réalisation avantageux, la zone active 21 se présente sous la forme d'un polygone régulier, à symétrie de rotation. Sur les exemples de réalisation des figures 3a à 3d, ce polygone comprend respectivement 4 (cas particulier du carré), 6, 8 et 12 côtés. En variante de réalisation, ce polygone pourrait être irrégulier, tout en gardant une symétrie de rotation, par exemple de forme rectangle, rectangle tronqué,...

Selon un mode de réalisation avantageux, les bras de traction 23 sont reliés à un côté 24 sur deux 24, 22 du polygone formant la zone active 21. En variante, toute combinaison d'un certain nombre de bras de traction 23 associés à une zone active comprenant un nombre de côtés multiples du nombre de bras de traction pourrait être envisagée, en répartissant de manière favorable les bras de traction de manière régulière, et symétrique autour de la zone active.

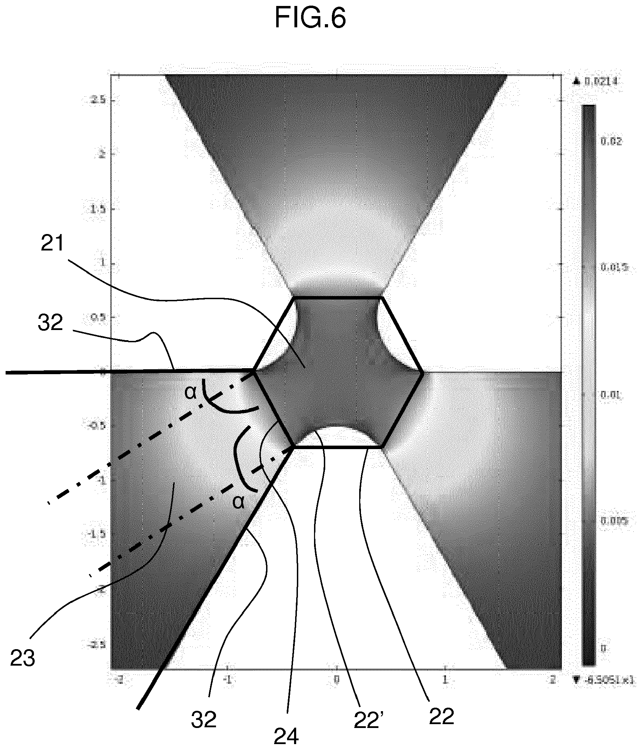

De plus, comme plus particulièrement représenté sur les figures 3a et 6, mais aussi vérifié sur les exemples des figures 3b à 3d, les bras de traction 23 présentent avantageusement des formes trapézoïdales, comprenant d'une part un petit côté 24 à la frontière avec la zone active 21, par définition parallèle à un côté de la zone active 21, et un plus grand côté 34 à l'opposé, parallèle au petit côté 24, reliés par deux côtés latéraux 32. Chaque bras de traction 23 comprend avantageusement une forme dont la largeur augmente en s'éloignant de la zone active 21. Chaque côté latéral 32 d'un bras de traction 23 forme un angle α obtus avec le côté 24 de la zone active 21 avec lequel il est relié, donc supérieur à 90 degrés. Le côté latéral 32 se trouve au-delà de la perpendiculaire P au côté 24 de la zone active 21, donnant une forme évasée au bras de traction 23. Les deux côtés latéraux 32 d'un bras de traction 23 ne sont pas parallèles entre eux. Ils s'éloignent de préférence symétriquement par rapport au côté 24 de la zone active 21, pour exercer des contraintes homogènes sur la zone active 21.

Les choix géométriques explicités précédemment permettent d'atteindre les avantages suivants :
- Les déformations de la membrane de germanium au niveau de la frontière 24 entre la zone active 21 et les bras de traction 23 sont améliorées, peuvent être augmentées sans risque de briser la structure en germanium, notamment du fait des angles obtus présents dans les angles au niveau de ces frontières, qui procurent une grande résistance ;
- Le fait d'utiliser des bras de traction 23 présentant une largeur qui augmente en s'éloignant de la zone active, notamment une forme évasée, par exemple trapézoïdale, permet de combiner l'avantage de pouvoir exercer une force importante sur la zone active tout en utilisant un nombre important de bras de traction, de préférence supérieur ou égal à trois, sans risque de chevauchement entre ces bras au niveau de la zone active qui est de petite dimension ;
- D'autre part, le fait de choisir une largeur des bras de traction correspondant à la longueur des côtés 24 de la zone active permet de multiplier le nombre de bras de traction liés à la zone active, notamment d'en utiliser au moins trois ;
- Le fait d'utiliser des bras de traction 23 présentant une largeur qui augmente en s'éloignant de la zone active permet aussi d'effectuer une étape de gravure du germanium sans exercer une force trop importante sur les bras de traction 23. Pour cela, une telle étape commencera avantageusement par la gravure de la couche sacrificielle au niveau de la zone active, pour libérer progressivement l'ensemble des bras de traction en s'éloignant de la zone active, avec une mise en tension progressive.

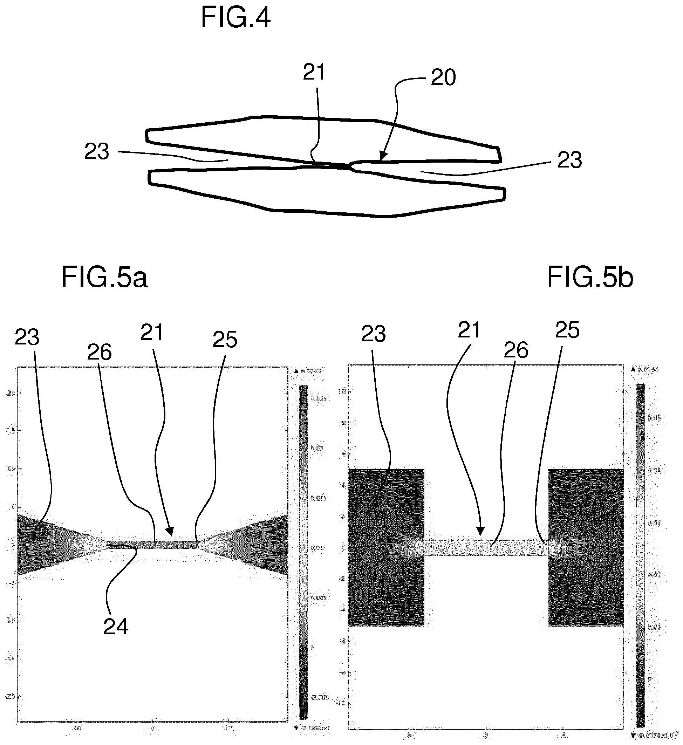

Naturellement, les géométries représentées par les figures 3a à 3d sont volontairement schématiques et parfaites. Dans la réalité, les formes obtenues seront moins régulières, moins parfaites, mais s'approcheront de ces formes. A titre d'exemple, la figure 4 montre la forme obtenue selon un exemple réel de fabrication d'une membrane 20 à deux bras de traction 23, s'approchant de la forme de la figure 3a.

Les figures 5a et 5b représentent des niveaux de déformation obtenus à l'aide d'un calculateur sur deux membranes exemplaires. Dans les deux simulations, la zone active 21 présente une largeur de 1 µm pour une longueur de 8 µm, et les bras de traction 23 présentent une longueur de 28 µm. Il apparait qu'avec deux bras de forme trapézoïdale, représenté par la figure 5a, les déformations (et donc les contraintes) obtenues au sein de la membrane présentent une bonne uniformité, plus précisément un rapport entre la déformation maximale observée dans les coins 25 de la zone active au niveau de la frontière 24 avec les bras de traction 23 et la déformation au centre 26 de l'ordre de 1,45. Dans l'exemple comparatif simulé avec deux bras de traction 23 rectangulaires, représenté par la figure 5b, le même rapport est de 2,57. Il en résulte qu'il est possible d'appliquer une déformation maximale beaucoup plus grande avec la réalisation représentée par la figure 5a avant la rupture de la membrane en germanium.

La figure 6 illustre aussi l'uniformité de la distribution des déformations au sein d'une membrane à trois bras de traction 23, de forme trapézoïdale, dans une réalisation proche de la géométrie de la figure 3b. En remarque, dans cette réalisation, il apparaît aussi qu'il est avantageux de former des côtés 22' courbés de la zone active 21, entre deux bras de traction 23, en remplacement des côtés 22 du polygone régulier. Ainsi, dans cette réalisation, la périphérie de la zone active 21 comprend des liaisons arrondies entre les bras de traction 23 voisins, formant une zone active 21 concave. Cette approche permet de supprimer les angles, ce qui réduit encore les zones de fortes contraintes. Ainsi, par forme polygonale de la zone active 21 de la membrane 20 selon l'invention, nous entendons aussi une forme avec des côtés 22' courbés. Avec une réalisation selon la figure 6, une déformation de 1,9% de la membrane est appliquée, tout en conservant un rapport de déformation de 1,13 seulement, ce qui démontre une grande uniformité de la répartition des contraintes au sein de la zone active.

Des variantes de réalisation ont été illustrées précédemment à titre d'exemples non limitatifs. Naturellement, d'autres formes de membranes peuvent être choisies tout en restant dans le cadre de l'invention. Notamment, tous les bras de traction peuvent ne pas être identiques, même s'il est avantageux d'utiliser des bras de même forme, uniformément répartis autour de la zone active, pour rechercher la géométrie la plus homogène possible. Il est généralement aussi préférable d'utiliser au moins trois bras de traction.

Finalement, l'invention est mise en oeuvre dès lors qu'au moins trois bras de traction 23 présentent chacun une largeur qui augmente en s'éloignant de la zone active, au moins sur une partie de la longueur de chaque bras. De plus, il a été montré des bras de traction relié à une zone active selon une largeur correspondant à un côté 24 d'un polygone de la zone active. Naturellement, la zone active peut présenter d'autres formes et la liaison entre un bras de traction 23 et la zone active 21 peut différer de la largeur d'un côté 24 d'un polygone. Enfin, même si l'invention permet avantageusement la réalisation de membranes entièrement en germanium, il est naturellement possible d'implémenter l'invention à partir d'un alliage à base de germanium, comme SiGe, SiGeSn, ou d'empilements de couches en matériaux différents à base de germanium.

Une telle membrane de germanium selon l'invention permet la réalisation de plusieurs types de dispositifs optiques et/ou électroniques. A titre d'exemples, nous pouvons citer une diode, un transistor, un dispositif luminescent comme un laser, un photodétecteur.

Dans ces exemples, le matériau sous contrainte est le matériau actif pour l'application envisagée. Mais ce matériau sous contrainte peut aussi être utilisé comme un nouveau matériau de substrat pour réaliser la croissance d'un autre matériau qui sera alors le matériau actif pour l'application envisagée. En effet, il est bien connu que la qualité de la croissance cristalline d'un matériau en couche mince sur un substrat est fortement dépendante de l'écart entre les paramètres de maille du substrat et de la couche : il faut que ces deux paramètres soient les plus proches possibles pour éviter les défauts de croissance. Habituellement, ce problème est résolu par exemple en déposant une couche intermédiaire tampon avant la croissance du matériau actif pour adapter les paramètres de maille mais ceci impose des étapes supplémentaires lors de la fabrication. Grâce à l'invention, on peut réaliser alors un substrat à la demande, dont le paramètre de maille sera ajusté à celui du matériau actif : il suffit d'appliquer les contraintes nécessaires pour étirer la structure cristalline du substrat jusqu'à obtention d'une maille la plus voisine possible de celle du matériau de croissance, puis de réaliser la croissance. Ces variations peuvent être importantes jusqu'à quelques pourcents.

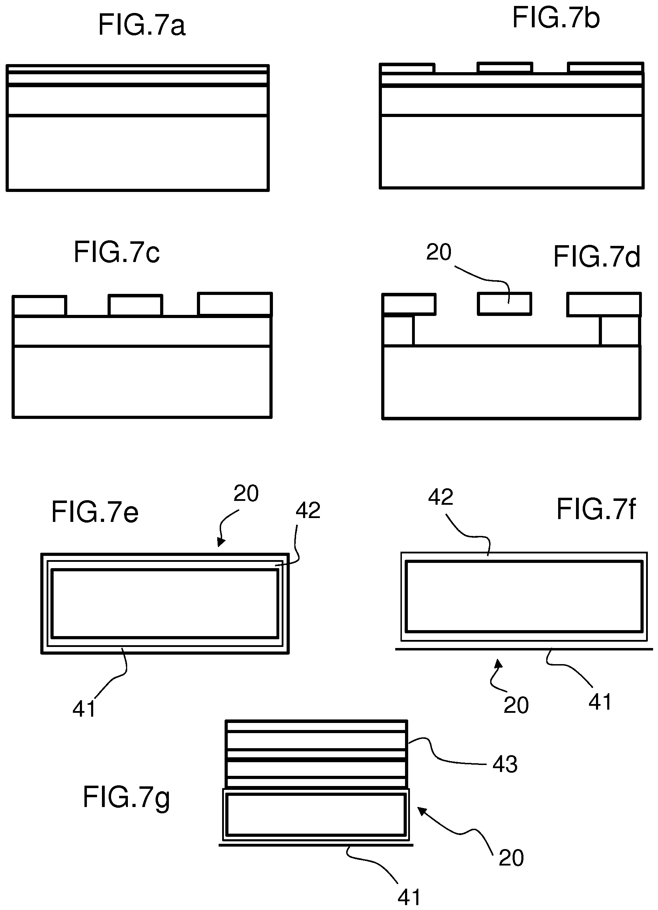

Les figures 7a à 7g représentent différentes étapes d'un procédé de fabrication d'un laser intégrant des membranes de germanium selon un mode de réalisation de l'invention, plus précisément un laser à cavité verticale émettant par la surface (VCSEL).

Les premières étapes de fabrication, représentées par les figures 7a à 7d, correspondent aux étapes décrites précédemment en référence avec les figures 1a à 1d pour obtenir une membrane en germanium. Dans cette réalisation, la forme des membranes 20 est choisie pour atteindre une déformation suffisante dans la zone active supérieure à 1,6%, pour obtenir l'effet laser à l'aide du germanium. Pour cela, la forme de la membrane 20 selon les figures 3b et 6 convient bien par exemple.

Le procédé comprend ensuite une étape supplémentaire consistant en un dépôt d'aluminium sur la membrane 20 de germanium, comme représenté par la figure 7e. Une étape supplémentaire supprime l'aluminium se trouvant au-dessus et sur les côtés de la membrane 20, pour ne laisser finalement que la couche d'aluminium sous la membrane, comme représenté par la figure 7f. Pour cela, une gravure par faisceau d'argon peut être mise en œuvre, en ayant pris soin de disposer une couche d'alumine 42 sous l'aluminium pour former une couche d'arrêt lors de cette gravure. L'aluminium forme ainsi un premier miroir 41.

Enfin, le dessus de la structure est recouvert d'un second miroir 43 conventionnel, par exemple un miroir diélectrique, notamment un miroir de Bragg. Pour cela, un dépôt par évaporateur de couches de faibles et forts indices peut être mis en œuvre, pour obtenir la membrane 20 illustrée par la figure 7g, comprenant deux miroirs inférieur et supérieur. Ces couches sont conçues de sorte à induire peu de contrainte et n'affectent pas la déformation de la membrane 20 dans la zone active.

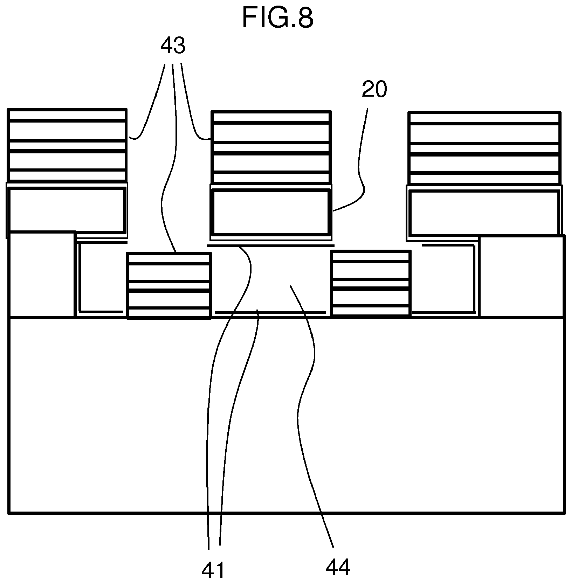

La figure 8 illustre la structure en coupe du laser obtenu, comprenant une cavité 44 comprenant les deux types de miroirs 41, 43.

D'autres configurations de laser peuvent être mises en œuvre en intercalant des couches entre la membrane et le miroir afin d'améliorer le rendement. De même, la cavité peut être réalisée dans le substrat 15. Enfin, pour réaliser un laser horizontal (dans lequel la lumière se propage dans le plan de la membrane), la membrane (zone active et/ou bras) peut être structurée à des dimensions comprises entre λ/10 et 10λ pour former un cristal photonique.

## Revendications

1. Dispositif optique et/ou électronique comprenant une membrane (20) à base de germanium suspendue, comprenant une zone active (21) mise en tension par des bras de traction (23), **caractérisé en ce qu'**il comprend au moins trois bras de traction (23) comprenant des côtés latéraux (32) non parallèles, dont la largeur augmente en s'éloignant de la zone active (21), et dont les côtés latéraux (32) forment un angle obtus avec la zone active (21) au niveau de la frontière entre le bras de traction (23) et la zone active (21).

2. Dispositif optique et/ou électronique selon la revendication précédente, **caractérisé en ce qu'**il comprend au moins un bras de traction (23) de forme trapézoïdale.

3. Dispositif optique et/ou électronique selon l'une des revendications précédentes, **caractérisé en ce que** tous les bras de traction (23) présentent une même forme et sont répartis de manière régulière autour de la zone active (21).

4. Dispositif optique et/ou électronique selon l'une des revendications précédentes, **caractérisé en ce qu'**il comprend une zone active (21) sensiblement polygonale, notamment formant un polygone régulier, dont le nombre de côtés (22, 24) est un multiple du nombre de bras de traction (23).

5. Dispositif optique et/ou électronique selon l'une des revendications précédentes, **caractérisé en ce qu'**il comprend des liaisons (22') arrondies au niveau de la périphérie de la zone active (21) reliant deux bras de traction (23).

6. Dispositif optique et/ou électronique selon l'une des revendications précédentes, **caractérisé en ce qu'**il est une diode, un transistor, un dispositif luminescent, un laser, un photodétecteur, un substrat.

7. Dispositif optique et/ou électronique selon la revendication précédente, **caractérisé en ce qu'**il est un dispositif optique et **en ce qu'**il comprend un premier miroir (41) sous la membrane (20) à base de germanium et/ou un second miroir (43) au-dessus.

8. Procédé de fabrication d'un dispositif optique et/ou électronique, **caractérisé en ce qu'**il comprend les étapes suivantes :
- gravure d'une couche (3 ; 13) à base de germanium pour former au moins trois bras de traction (23) comprenant des côtés latéraux (32) non parallèles, dont la largeur augmente en s'éloignant d'une zone active (21), et dont les côtés latéraux (32) forment un angle obtus avec la zone active (21) au niveau de la frontière entre le bras de traction (23) et la zone active (21);
- gravure d'une couche sacrificielle (4 ; 15) sous la couche (3 ; 13) à base de germanium pour obtenir une membrane (20) à base de germanium suspendue comprenant la zone active (21) et le au moins un bras de traction (23).

9. Procédé de fabrication d'un dispositif optique et/ou électronique selon la revendication précédente, **caractérisé en ce que** l'étape de gravure de la couche sacrificielle s'étend progressivement du centre de la membrane (20), au niveau de la zone active (21), jusqu'au bord extérieur des bras de traction (23).

10. Procédé de fabrication d'un dispositif optique et/ou électronique selon la revendication 8 ou 9, **caractérisé en ce qu'**il comprend une étape de dépôt d'une couche réfléchissante pour former un miroir (41), notamment d'aluminium, sous la membrane (20) et/ou une seconde étape de dépôt d'une couche réfléchissante pour former un miroir sur la membrane.

## Patentansprüche

1. Optische und/oder elektronische Vorrichtung, welche eine aufgehängte Membran (20) auf der Basis von Germanium umfasst, die einen aktiven Bereich (21) umfasst, der von Zugarmen (23) gespannt wird, **dadurch gekennzeichnet, dass** sie wenigstens drei Zugarme (23) umfasst, die nicht parallele laterale Seiten (32) umfassen, deren Breite mit zunehmendem Abstand vom aktiven Bereich (21) zunimmt und deren laterale Seiten (32) an der Grenze zwischen dem Zugarm (23) und dem aktiven Bereich (21) einen stumpfen Winkel mit dem aktiven Bereich (21) bilden.

2. Optische und/oder elektronische Vorrichtung nach dem vorhergehenden Anspruch, **dadurch gekennzeichnet, dass** sie wenigstens einen Zugarm (23) von trapezförmiger Gestalt umfasst.

3. Optische und/oder elektronische Vorrichtung nach einem der vorhergehenden Ansprüche, **dadurch gekennzeichnet, dass** alle Zugarme (23) dieselbe Form aufweisen und regelmäßig um den aktiven Bereich (21) herum verteilt sind.

4. Optische und/oder elektronische Vorrichtung nach einem der vorhergehenden Ansprüche, **dadurch gekennzeichnet, dass** sie einen im Wesentlichen polygonalen aktiven Bereich (21), der insbesondere ein regelmäßiges Vieleck bildet, umfasst, dessen Anzahl der Seiten (22, 24) ein Vielfaches der Anzahl der Zugarme (23) ist.

5. Optische und/oder elektronische Vorrichtung nach einem der vorhergehenden Ansprüche, **dadurch gekennzeichnet, dass** sie am Umfang des aktiven Bereichs (21) abgerundete Verbindungen (22') umfasst, welche zwei Zugarme (23) verbinden.

6. Optische und/oder elektronische Vorrichtung nach einem der vorhergehenden Ansprüche, **dadurch gekennzeichnet, dass** sie eine Diode, ein Transistor, eine Lumineszenzvorrichtung, ein Laser, ein Fotodetektor, ein Substrat ist.

7. Optische und/oder elektronische Vorrichtung nach dem vorhergehenden Anspruch, **dadurch gekennzeichnet, dass** sie eine optische Vorrichtung ist, und dadurch, dass sie einen ersten Spiegel (41) unter der Membran (20) auf der Basis von Germanium und/oder einen zweiten Spiegel (43) darüber umfasst.

8. Verfahren zur Herstellung einer optischen und/oder elektronischen Vorrichtung, **dadurch gekennzeichnet, dass** es die folgenden Schritte umfasst:
- Ätzen einer Schicht (3; 13) auf der Basis von Germanium, um wenigstens drei Zugarme (23) zu bilden, die nicht parallele laterale Seiten (32) umfassen, deren Breite mit zunehmendem Abstand von einem aktiven Bereich (21) zunimmt und deren laterale Seiten (32) an der Grenze zwischen dem Zugarm (23) und dem aktiven Bereich (21) einen stumpfen Winkel mit dem aktiven Bereich (21) bilden;
- Ätzen einer Opferschicht (4; 15) unter der Schicht (3; 13) auf der Basis von Germanium, um eine aufgehängte Membran (20) auf der Basis von Germanium zu erhalten, die den aktiven Bereich (21) und den wenigstens einen Zugarm (23) umfasst.

9. Verfahren zur Herstellung einer optischen und/oder elektronischen Vorrichtung nach dem vorhergehenden Anspruch, **dadurch gekennzeichnet, dass** der Schritt des Ätzens der Opferschicht fortschreitend vom Mittelpunkt der Membran (20) am aktiven Bereich (21) bis zum äußeren Rand der Zugarme (23) ausgeführt wird.

10. Verfahren zur Herstellung einer optischen und/oder elektronischen Vorrichtung nach Anspruch 8 oder 9, **dadurch gekennzeichnet, dass** es einen Schritt der Aufbringung einer reflektierenden Schicht, um einen Spiegel (41), insbesondere aus Aluminium, unter der Membran (20) auszubilden, und/oder einen zweiten Schritt der Aufbringung einer reflektierenden Schicht, um einen Spiegel auf der Membran auszubilden, umfasst.

## Claims

1. Optical and/or electronic device comprising a suspended, germanium-based membrane (20) and comprising an active zone (21) placed under tension by tensioning arms (23), said device being **characterized in that** it comprises at least three tensioning arms (23) comprising nonparallel lateral sides (32), the width of which increases with distance from the active zone (21), and the lateral sides (32) of which make an obtuse angle to the active zone (21) at the junction between the tensioning arm (23) and the active zone (21).

2. Optical and/or electronic device according to the preceding claim, **characterized in that** it comprises at least one trapezoidal-shaped tensioning arm (23).

3. Optical and/or electronic device according to one of the preceding claims, **characterized in that** all the tensioning arms (23) have the same shape and are distributed regularly about the active zone (21).

4. Optical and/or electronic device according to one of the preceding claims, **characterized in that** it comprises a substantially polygonal active zone (21), especially forming a regular polygon, the number of sides (22, 24) of which is a multiple of the number of tensioning arms (23).

5. Optical and/or electronic device according to one of the preceding claims, **characterized in that** it comprises links (22') that are rounded on the periphery of the active zone (21) connecting two tensioning arms (23).

6. Optical and/or electronic device according to one of the preceding claims, **characterized in that** it is a diode, a transistor, a light-emitting device, a laser, a photodetector or a substrate.

7. Optical and/or electronic device according to the preceding claim, **characterized in that** it is an optical device and **in that** it comprises a first mirror (41) under the germanium-based membrane (20) and/or a second mirror (43) above the germanium-based membrane (20).

8. Process for fabricating an optical and/or electronic device, **characterized in that** it comprises the following steps:
- etching a germanium-based layer (3; 13) in order to form at least three tensioning arms (23) comprising nonparallel lateral sides (32), the width of which increases with distance from an active zone (21), and the lateral sides (32) of which make an obtuse angle to the active zone (21) at the junction between the tensioning arm (23) and the active zone (21) ;
- etching a sacrificial layer (4; 15) under the germanium-based layer (3; 13) in order to obtain a suspended, germanium-based membrane (20) comprising the active zone (21) and the at least one tensioning arm (23).

9. Process for fabricating an optical and/or electronic device according to the preceding claim, **characterized in that** the step of etching the sacrificial layer extends gradually from the centre of the membrane (20), at the level of the active zone (21), as far as the outside edge of the tensioning arms (23).

10. Process for fabricating an optical and/or electronic device according to Claim 8 or 9, **characterized in that** it comprises a step of depositing a reflective layer in order to form a mirror (41), especially of aluminium, under the membrane (20) and/or a second step of depositing a reflective layer in order to form a mirror on the membrane.
